# FASCICULE DE BREVET EUROPEEN

(11) **EP 2 653 021 B1**
(45) Date de publication et mention de la délivrance du brevet: **21.01.2015**
(21) Numéro de dépôt: 11796716.6
(22) Date de dépôt: 16.12.2011
(51) Int. Cl.: H05K 7/14, H05K 7/20

(54) **REFROIDISSEMENT D'UN EQUIPEMENT ELECTRONIQUE**
KÜHLUNG EINER ELEKTRONISCHEN VORRICHTUNG
COOLING AN ELECTRONIC DEVICE

(30) Priorité: 17.12.2010 FR 1004934
(43) Date de publication de la demande: 23.10.2013
(73) Titulaire: THALES, 92200 Neuilly-sur-Seine (FR)
(72) Inventeur: TANTOLIN, Christian, F-38660 Lumbin (FR); SARNO, Claude, F-26800 Etoile sur Rhone (FR)
(74) Mandataire: Collet, Alain
(86) Numéro de dépôt international: PCT/EP2011/073107
(87) Numéro de publication internationale: WO 2012/080493

(56) Documents cités:
- US-A1- 2008 019 102
- US-A1- 2008 043 442

## Description

L'invention concerne le refroidissement d'un équipement électronique comprenant un boitier et des cartes électroniques enfichées dans le boitier. L'invention trouve une utilité particulière pour des équipements électroniques embarqués comme par exemple à bord d'un aéronef.

On trouve par exemple des calculateurs comprenant plusieurs cartes électroniques assemblées parallèlement les unes aux autres dans un boitier encore appelé panier ou rack. Afin d'assurer la maintenance de l'équipement les différents cartes sont démontables. Le montage et le démontage des cartes se fait par translation de celle-ci dans des rainures appartenant au boitier.

Les cartes sont formées d'un circuit imprimé portant des composants électroniques. Lors de leur fonctionnement, les composants électroniques dégagent de la chaleur qu'il est nécessaire d'évacuer hors de l'équipement électronique.

Plusieurs solutions ont été envisagées pour le refroidissement d'équipements électroniques. On peut par exemple faire circuler un fluide caloporteur, comme par exemple de l'air, le long des cartes ou au voisinage immédiat des composants et les refroidir ainsi par convection forcée.

On peut également équiper la carte à refroidir d'un drain thermique sous forme d'une plaque réalisée dans un matériau à forte conductivité thermique, comme par exemple du cuivre ou de l'aluminium, les composants étant en contact avec ce drain. La plaque a sensiblement la même surface que le circuit imprimé et est parallèle à celui-ci. Cette plaque permet de conduire la chaleur à évacuer des composants électroniques vers le boitier. Ce dernier est alors chargé de dissiper la chaleur collectée vers l'extérieur de l'équipement. Cette dissipation peut être obtenue simplement en réalisant le boitier dans un matériau à forte conductivité thermique ou en plaçant dans le boitier un échangeur thermique. A cet effet, on peut intégrer au boitier des canaux dans lesquels circulent par exemple de l'air ou de l'eau. Il est alors nécessaire de raccorder ces canaux vers un réseau de refroidissement externe à l'équipement.

Ces solutions permettent de refroidir globalement l'équipement mais ne s'intéressent pas à d'éventuels points chauds, formés au niveau de certains composants particuliers. Pour maintenir ces composants a des températures de fonctionnement acceptables, on est tenu d'augmenter globalement le refroidissement de l'équipement par exemple en augmentant les débits des fluides caloporteurs. Ceci augmente les pertes de charge dans les circuits de refroidissement au delà de ce qui serait nécessaire pour refroidir globalement l'équipement.

Pour refroidir des zones particulières de cartes, on peut placer en contact direct avec le composant à refroidir un élément, comme par exemple un caloduc, permettant d'évacuer par conduction la chaleur directement au niveau du composant. Une extrémité du caloduc est en contact avec le composant et l'autre extrémité doit permettre l'évacuation de la chaleur vers l'extérieur de l'équipement. L'implantation de ce type de composant rend plus difficile le démontage des cartes électroniques.

Dans certains domaines, notamment en aéronautique, le remplacement de cartes électroniques doit pouvoir se faire en un temps réduit lors d'escales afin de ne pas immobiliser le porteur. Il est donc nécessaire de conserver le même temps de remplacement d'une carte, que celle-ci soit équipée ou non de moyens particulier de refroidissement.

L'invention vise à pallier tout ou partie des problèmes cités plus haut en proposant un équipement électronique dans lequel les cartes sont normalement assemblées par translation dans des rainures même en présence de point chaud particulier.

A cet effet, l'invention a pour objet un équipement électronique comprenant un compartiment électronique formé d'un boitier et d'au moins une carte portant des composants électroniques, la carte étant destinée à être assemblée de façon démontable dans le boitier par translation le long d'une rainure pour atteindre une position de fonctionnement, l'assemblage de la carte se faisant par une face d'insertion du boitier, caractérisé en ce qu'il comprend un drain thermique de forme longiligne disposé le long de la rainure permettant de prélever de la chaleur émise par les composants et des moyens d'extraction de la chaleur prélevée par le drain thermique, les moyens d'extraction étant situés à l'extérieur du compartiment électronique, soit au niveau de la face d'insertion, soit au niveau d'une face arrière opposée à la face d'insertion.

Autrement dit, l'échange thermique se fait principalement par un des bouts du drain thermique sans passer par des surfaces en contact entre le drain therrmique et la rainure.

Le fait de mettre en oeuvre un drain thermique de forme longiligne disposé le long de la rainure permet d'homogénéiser la température du drain thermique et de prélever la chaleur produite dans la carte sur toute la longueur de la rainure et donc sur la plus grande surface de contact possible entre la carte et le boitier.

L'invention sera mieux comprise et d'autres avantages apparaîtront à la lecture de la description détaillée d'un mode de réalisation donné à titre d'exemple, description illustrée par le dessin joint dans lequel :
les figures 1a, 1b et 1c représentent un premier mode de réalisation d'un équipement électronique selon l'invention ;
les figures 2a, 2b, 2c et 2d représentent un second mode de réalisation d'un équipement électronique selon l'invention.

Par souci de clarté, les mêmes éléments porteront les mêmes repères dans les différentes figures.

Les différentes figures représentent un équipement électronique comprenant un boîtier 10 contenant plusieurs cartes de circuits imprimés, dont une seule, référencée 11, a été représentée sur le dessin. Sur cette carte 11 de nombreux composants électroniques sont implantés dont un seul, le composant 12, est référencé ici. Ce composant nécessite un refroidissement particulier. Il peut s'agir d'un transistor de puissance ou d'un circuit numérique de type processeur.

Les différentes cartes sont enfichées dans le boitier 10 par sa face avant 17 ou plus généralement par une face d'insertion. Les connexions électriques des différentes cartes entre elles sont réalisées en fond de panier au niveau d'une face opposée à la face d'insertion, dans l'exemple représenté, la face arrière 18 du boitier 10. Les cartes sont guidées chacune dans deux rainures parallèles et opposées. L'enfichage d'une carte est réalisé par translation dans les rainures qui lui sont réservées en direction du fond de panier. Le démontage de la carte s'effectue très simplement par translation inverse. Il est donc aisé de remplacer une carte en cas de dysfonctionnement de celle-ci. On entend par compartiment électronique l'ensemble formé par le boitier 10 et la ou les cartes enfichables 11. L'équipement peut comprendre d'autres sous ensembles fixés au boitier 10, comme par exemple une alimentation.

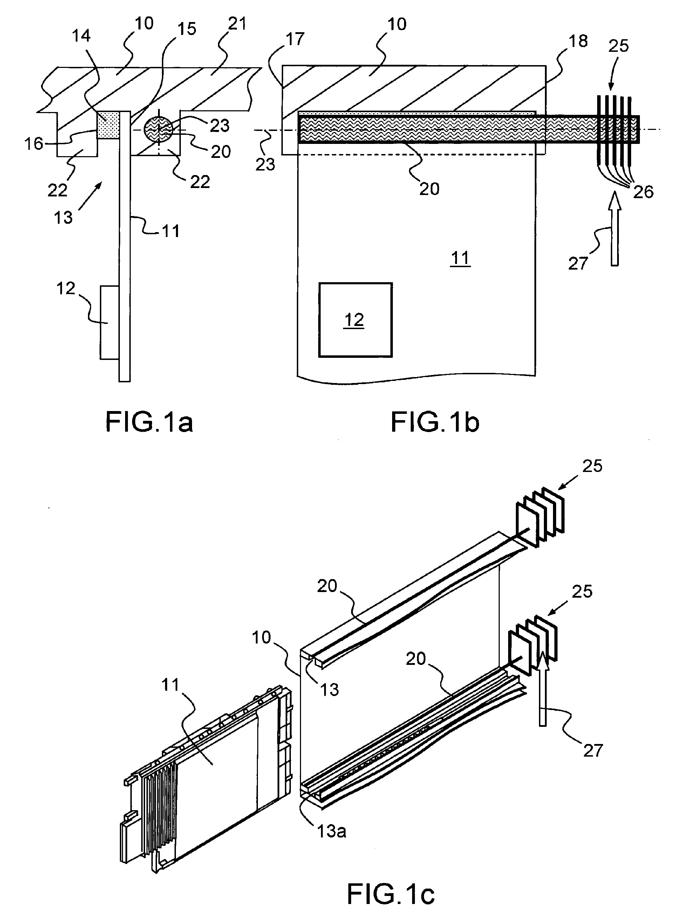

Les figures 1a, 1b et 1c représentent un premier mode de réalisation de l'invention. Plus précisément, la figure 1 a représente, en coupe partielle vue par la face avant 17 du boitier 10, la carte 11 dans une de ses rainures 13. La figure 1b représente en vue partielle la carte 11 de profil dans le boitier 10 et la figure 1c représente en perspective la carte 11 hors du boitier 10.

La rainure 13 est réalisée dans le corps du boitier 10 perpendiculairement à la face avant 17 du boitier 10. Un dispositif de serrage 14 permet d'assurer le plaquage de la carte 11 sur une des faces 15 de la rainure 13. Le dispositif 14 prend appui contre une face 16 de la rainure 13 opposée à la face 15. La carte 11 est pincée entre le dispositif de serrage 14 et la face 15.

La carte 11 peut comprendre des moyens spécifiques destinés à améliorer la conduction thermique entre le composant 12 et la rainure 13. Il peut s'agir d'une plaque de cuivre recouverte d'une peinture isolante électriquement et conductrice thermiquement disposée parallèlement au circuit imprimé entre celui-ci et le composant 12. La plaque de cuivre est percée au pas des composants électroniques implantés sur la carte 11 afin de permettre le raccordement des composants au circuit imprimé. La plaque de cuivre se prolonge jusqu'à la rainure 13. Le circuit imprimé peut être interrompu avant la rainure 15. Ainsi, seule la plaque de cuivre est pincée entre la face 15 et le dispositif de serrage 14. Ce qui assure un bon contact thermique entre la plaque de cuivre et le boitier 10. Dans ce type de réalisation, le dispositif de serrage est souvent appelé glissière thermique qui peut par exemple comprendre plusieurs coins que l'on peut déplacer les uns par rapport aux autres au moyen d'une vis manoeuvrable par la face avant 17 du boitier 10.

Selon l'invention l'équipement électronique comprend un drain thermique 20 de forme longiligne disposé le long de la rainure 13 et permettant de prélever de la chaleur émise par les composants de la carte 11 pour l'évacuer vers une face arrière 18 du boitier 10, la face arrière 18 étant opposée à la face avant 17. Le drain thermique 20 est un composant rapporté dans le boitier 10. Il a une conductivité thermique supérieure à celle du corps du boitier 10 dans lequel il est inséré. En mettant en oeuvre un composant rapporté, on a moins de contraintes sur la conductivité thermique du matériau formant le boitier 10. Il est par exemple possible de réaliser le boitier 10 en matériau composite ce qui permet un gain de masse substantiel par rapport à un matériau métallique.

On peut par exemple mettre en oeuvre un drain diphasique tel qu'un caloduc ou une boucle diphasique ou encore un drain à haute conductivité thermique tel qu'un barreau de graphite, de diamant ou à base de nanotubes de carbone.

Le drain thermique 20 est associé à des moyens d'extraction hors de l'équipement de la chaleur prélevée par le drain thermique 20, les moyens d'extraction peuvent être situés au niveau de la face arrière 18 du boitier 10. On peut également disposer les moyens d'extraction au niveau de la face avant 17. L'évacuation de la chaleur prélevée par le drain thermique 20 se fait principalement par les moyens d'extraction, sans transiter par le boitier 10.

Lorsque l'équipement comprend plusieurs cartes enfichables, chacune dans une paire de rainures, on peut associer à chaque rainure un drain thermique 20 et des moyens d'extraction qui sont propres à ce drain thermique 20 et sont distincts les uns des autres. Les différents drains thermiques 20 et moyens d'extractions sont avantageusement identiques.

Cela permet une meilleure modularité de l'invention qui peut être mise en oeuvre dans un équipement en fonction du besoin. Certaines cartes peuvent être équipées d'un drain thermique 20 et de ses propres moyens d'extraction et d'autres non. On peut ainsi modifier à moindre frais un équipement existant sans toucher au boitier 10 lui-même. Cela peut être utile par exemple lors du remplacement d'une carte 11 par une nouvelle carte plus consommatrice d'énergie et devant être mieux refroidie. Pour la carte d'origine, aucun drain thermique n'était prévu. Sans modification du boitier 10, il est possible d'ajouter un drain thermique 20 et ses moyens d'extraction associés afin d'accueillir la nouvelle carte.

Dans le premier mode de réalisation de l'invention, le drain thermique 20 est solidaire du boitier 10. Plus précisément, le boitier 10 comprend une plaque 21 et une excroissance 22 débordant de la plaque 21 et limitée par la face 15 sur laquelle s'appuie la carte 11. La plaque 21 peut comprendre plusieurs excroissances 22 entre lesquelles sont formées les rainures 13. Le drain thermique 20 est disposé dans l'excroissance 22. Il s'étend selon un axe 23 parallèlement au plan de la carte 11.

Le drain thermique 20 se prolonge au-delà de la face arrière 18 pour former les moyens d'extraction 25. Sur la figure 1b, les moyens d'extraction 25 comprennent des ailettes 26 solidaires du drain thermique 20. Un flux d'air 27 refroidit par convection forcée les ailettes 26 afin d'extraire hors de l'équipement la chaleur prélevée par le drain thermique 20. D'autres alternatives sont envisageables pour réaliser les moyens d'extraction 25, comme par exemple l'utilisation d'un liquide de refroidissement. De façon plus générale, les moyens d'extraction 25 permettent de raccorder le drain thermique vers une source froide externe à l'équipement. Cette source froide peut être un élément mécanique comme un cadre métallique supportant le boitier 10 ou la structure du porteur dans le cas d'un équipement embarqué.

Dans le cas où le drain thermique 20 est diphasique, la partie du drain s'étendant le long de la rainure 13 forme un évaporateur et les moyens d'extraction 25 forment un condenseur.

Sur la figure 1c, on distingue deux rainures opposées 13 et 13a permettant l'enfichage de la carte 11. En fonction du besoin en refroidissement de la carte 11, il est possible de placer un drain thermique 20 le long de chaque rainure 13 et 13a. Dans ce cas, chacun des drains thermiques 20 est prolongé par des moyens d'extractions 25 qui peuvent être refroidi par la même source froide formée par le flux d'air 27 dans l'exemple représenté.

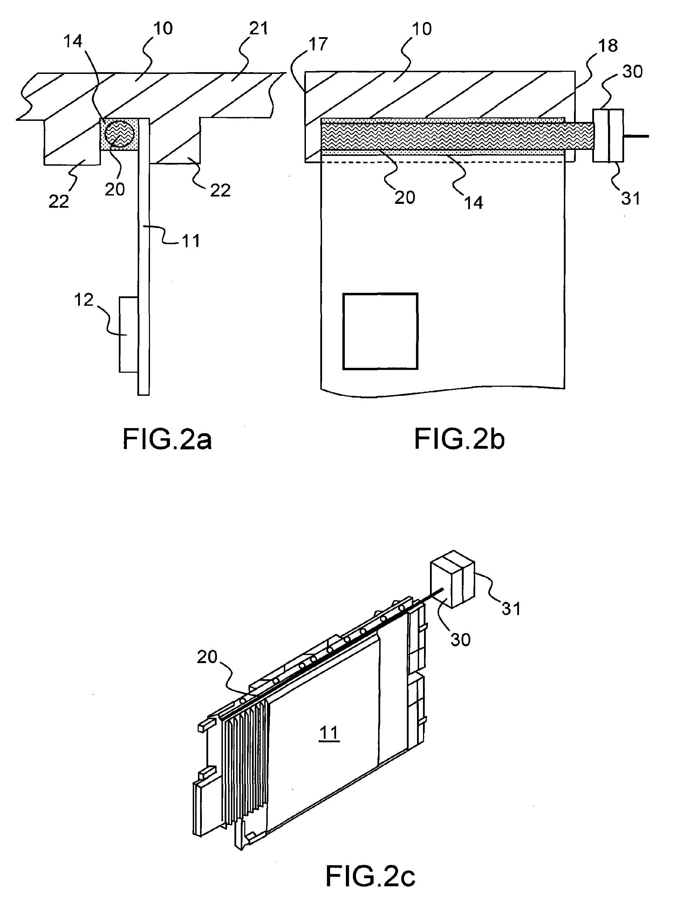

Dans le second mode de réalisation de l'invention, représenté à l'aide des figures 2a, 2b et 2c, le drain thermique 20 est solidaire de la carte 11. Ainsi, les différentes cartes équipant un boitier 10 peuvent être équipée ou non d'un drain thermique 20 en fonction des besoins de refroidissement de la carte 11. Par exemple en cas d'évolution matériel dans laquelle une carte doit être remplacée par une nouvelle carte plus récente, même si l'ancienne carte ne nécessitait pas de drain thermique, on peut accepter une nouvelle carte devant dissiper plus de chaleur en l'équipant d'un drain thermique. Cette évolution peut se faire sans modification du boitier 10.

La figure 2a représente, en coupe partielle vue par la face avant 17 du boitier 10, la carte 11 dans une de ses rainures, la rainure 13. La figure 2b représente en vue partielle la carte 11 de profil dans le boitier 10 et la figure 2c représente en perspective la carte 11 dans le boitier 10.

Dans le second mode de réalisation, le ou les excroissances 22 ont uniquement pour fonction de guider la carte 11. Avantageusement le drain thermique 20 est réalisé dans le dispositif de serrage 14. Le serrage du dispositif 14 assure alors un bon contact thermique entre la carte 11 et le drain thermique 20.

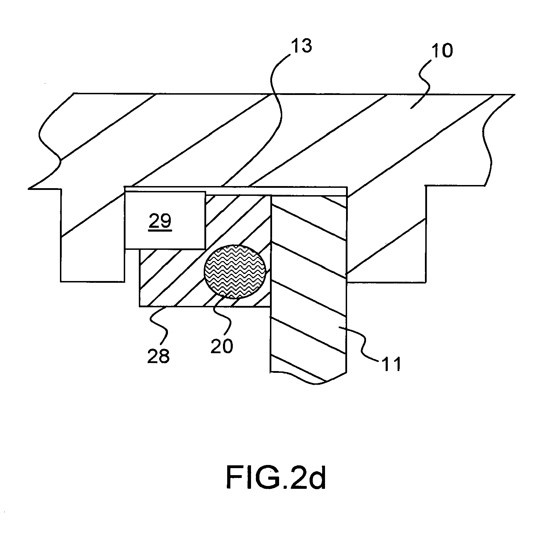

La figure 2d représente, sous forme de vue agrandie, un exemple de réalisation du dispositif de serrage 14 de la carte 11 dans la rainure 13. Le dispositif 14 comprend une équerre 28 s'étendant le long d'un bord de la carte 11 et dans laquelle est disposé le drain thermique 20. L'équerre 28 est réalisée dans un matériau ayant une bonne conductivité thermique tel que par exemple l'aluminium. On peut mettre en oeuvre d'autres matériaux ayant une meilleure conductivité thermique tel que du cuivre. L'aluminium présente néanmoins l'avantage d'une plus grande légèreté, avantage important dans une utilisation aéronautique embarquée. Le dispositif 14 comprend également une glissière thermique 29, par exemple à coins assurant la fonction de serrage. La glissière thermique 29 est disposée dans le creux de l'équerre 28. Elle prend appui contre la face 16 de la rainure 13 pour exercer un effort de serrage en direction de la face 15 de la rainure 13. L'équerre 28 est fixée à la carte 11 et la glissière thermique 29 est fixée à l'équerre.

Le drain thermique 20 est associé aux moyens d'extraction 25 qui dans ce mode de réalisation comprennent un connecteur thermique 30 permettant de raccorder le drain thermique 20 à une source froide 31 externe à l'équipement. Un exemple de connecteur thermique 30 est décrit dans la demande de brevet publiée sous le numéro : FR 2 920 949. La source froide peut, comme dans le premier mode de réalisation être formées d'ailettes 26 ou de tout autre moyen permettant de refroidir le drain thermique 20. La fonction de connexion thermique peut également être assurée par le connecteur électrique de la carte situé en fond de panier. Ce connecteur associé au connecteur du panier permet de délimiter un canal d'air dans lequel il est possible de faire circuler de l'air plus froid ou en surpression par rapport au milieu ambiant.

On peut mettre en oeuvre un connecteur thermique 30 dans le premier mode de réalisation.

Sur la figure 2c, un seul drain thermique 20 a été représenté. Il est bien entendu possible d'équiper la carte 11 de deux drains thermiques 20 associés chacun à leur propre moyen d'extraction 25, comme illustré sur la figure 1 c.

## Revendications

1. Equipement électronique comprenant un compartiment électronique formé d'un boitier (10) et d'au moins une carte (11) portant des composants électroniques (12), la carte (11) étant destinée à être assemblée de façon démontable dans le boitier (10) par translation le long d'une rainure (13, 13a) pour atteindre une position de fonctionnement, l'assemblage de la carte (11) se faisant par une face d'insertion (17) du boitier (10), **caractérisé en ce qu'**il comprend un drain thermique (20) de forme longiligne disposé le long de la rainure (13, 13a) permettant de prélever de la chaleur émise par les composants (12) et des moyens d'extraction (25, 30) de la chaleur prélevée par le drain thermique (20), les moyens d'extraction (25, 30) étant situés à l'extérieur du compartiment électronique, soit au niveau de la face d'insertion (17), soit au niveau d'une face arrière (18) opposée à la face d'insertion (17).

2. Equipement électronique selon la revendication 1, **caractérisé en ce qu'**il comprend plusieurs cartes (11) assemblées chacune de façon démontable dans le boitier (10) par translation le long d'une rainure (13, 13a) pour atteindre une position de fonctionnement et **en ce qu'**il comprend plusieurs drains thermiques (20) identiques, associés chacun à une rainure (13, 13a) et à ses propres moyens d'extraction (25, 30).

3. Equipement électronique selon l'une des revendications précédentes, **caractérisé en ce que** le drain thermique (20) est solidaire du boitier (10).

4. Equipement électronique selon la revendication 3, **caractérisé en ce que** le drain thermique (20) est un composant rapporté dans le boitier (10) et **en ce que** le drain thermique (20) a une conductivité thermique supérieure à celle du boitier (10).

5. Equipement électronique selon la revendication 3, **caractérisé en ce que** le boitier (10) comprend une plaque (21) et une excroissance (22) débordant de la plaque 21, excroissance 22 sur laquelle s'appuie la carte (11) et **en ce que** le drain thermique (20) est disposé dans l'excroissance (22).

6. Equipement électronique selon l'une quelconques des revendications 1 ou 2, **caractérisé en ce que** le drain thermique (20) est solidaire de la carte (11).

7. Equipement électronique selon la revendication 6, **caractérisé en ce qu'**il comprend une équerre (28) fixée à la carte (11) et une glissière thermique (29) fixée à l'équerre (28), **en ce que** le drain thermique (20) est disposé dans l'équerre (28) et **en ce que** la glissière thermique (29) assure le plaquage de la carte (11) sur une face (15) de la rainure (13).

8. Equipement électronique selon l'une des revendications précédentes, **caractérisé en ce que** les moyens d'extraction (25) comprennent un connecteur thermique (30) permettant de raccorder le drain thermique (20) à une source froide (31) externe à l'équipement.

9. Equipement électronique selon l'une des revendications précédentes, **caractérisé en ce que** les moyens d'extraction (25, 30) sont situés au niveau de la face arrière (18).

## Patentansprüche

1. Elektronische Ausrüstung, die ein von einem Gehäuse (10) und von mindestens einer elektronische Bauteile (12) tragenden Karte (11) gebildetes elektronisches Abteil umfasst, wobei die Karte (11) für die lösbare Montage in dem Gehäuse (10) durch Verschieben entlang einer Rille (13, 13a), um eine Funktionsposition zu erreichen, bestimmt ist, wobei die Montage der Karte (11) über eine Einfügefläche (17) des Gehäuses (10) erfolgt, **dadurch gekennzeichnet, dass** sie eine längliche Wärmeabführung (20), die entlang der Rille (13, 13a) angeordnet ist, die erlaubt, die von den Bauteilen (12) abgestrahlte Wärme abzuführen, und Extraktionsmittel (25, 30) der von der Wärmeabführung (20) abgestrahlten Wärme umfasst, wobei sich die Extraktionsmittel (25, 30) außerhalb des elektronischen Abteils entweder auf Ebene der Einfügefläche (17) oder auf Ebene einer rückseitigen Fläche (18) gegenüber der Einfügefläche (17) befinden.

2. Elektronische Ausrüstung nach Anspruch 1, **dadurch gekennzeichnet, dass** sie mehrere Karten (11) umfasst, die jeweils lösbar in dem Gehäuse (10) durch Verschieben entlang einer Rille (13, 13a), um eine Funktionsposition zu erreichen, montiert sind, und dass sie mehrere identische Wärmeabführungen (20) umfasst, die jeweils einer Rille (13, 13a) und ihren eigenen Extraktionsmitteln (25, 30) zugeordnet sind.

3. Elektronische Ausrüstung nach einem der vorangehenden Ansprüche, **dadurch gekennzeichnet, dass** die Wärmeabführung (20) mit dem Gehäuse (10) verbunden ist.

4. Elektronische Ausrüstung nach Anspruch 3, **dadurch gekennzeichnet, dass** die Wärmeabführung (20) ein in das Gehäuse (10) eingesetztes Bauteil ist und dass die Wärmeabführung (20) einen höhere elektrische Leitfähigkeit als die des Gehäuses (10) hat.

5. Elektronische Ausrüstung nach Anspruch 3, **dadurch gekennzeichnet, dass** das Gehäuse (10) eine Platte (21) und eine über die Platte (21) hinausragende Ausstülpung (22) umfasst, wobei sich die Karte (11) auf der Ausstülpung (22) abstützt, und dass die Wärmeabführung (20) in der Ausstülpung (22) angeordnet ist.

6. Elektronische Ausrüstung nach einem der Ansprüche 1 oder 2, **dadurch gekennzeichnet, dass** die Wärmeabführung (20) mit der Karte (11) fest verbunden ist.

7. Elektronische Ausrüstung nach Anspruch 6, **dadurch gekennzeichnet, dass** sie einen an der Karte (11) befestigten Winkel (28) und eine am Winkel (28) befestigte Thermoschiene (29) umfasst, dass die Wärmeabführung (20) in dem Winkel (28) angeordnet ist und dass die Thermoschiene (29) das Auflegen der Karte (11) auf einer Fläche (15) der Rille (13) sichert.

8. Elektronische Ausrüstung nach einem der vorangehenden Ansprüche, **dadurch gekennzeichnet, dass** die Extraktionsmittel (25) einen Thermoverbinder (30) umfassen, der den Anschluss der Wärmeabführung (20) an eine zur Ausrüstung externe kalte Quelle (31) erlaubt.

9. Elektronische Ausrüstung nach einem der vorangehenden Ansprüche, **dadurch gekennzeichnet, dass** sich die Extraktionsmittel (25, 30) auf Ebene der rückseitigen Fläche (18) befinden.

## Claims

1. The item of electronic equipment comprising an electronic compartment formed from a housing (10) and at least one board (11) carrying electronic components (12), the board (11) being intended for assembly in a removable manner in the housing (10) by a movement of translation along a groove (13, 13a) in order to reach an operating position, the assembly of the board (11) being carried out through an insertion face (17) of the housing (10), **characterized in that** it comprises a heat sink (20) of elongate shape disposed along the groove (13, 13a) making it possible to collect the heat emitted by the components (12) and means of extraction (25, 30) of the heat collected by the heat sink (20), the extraction means (25, 30) being located outside of the electronic compartment, either at the level of the insertion face (17) or at the level of a rear face (18) opposite the insertion face (17).

2. The item of electronic equipment as claimed in claim 1, **characterized in that** it comprises several boards (11) each assembled in a removable manner in the housing (10) by a movement of translation along a groove (13, 13a) in order to reach an operating position and **in that** it comprises several identical heat sinks (20), each associated with a groove (13, 13a) and with its own extraction means (25, 30).

3. The item of electronic equipment as claimed in one of the preceding claims, **characterized in that** the heat sink (20) is integral with the housing (10).

4. The item of electronic equipment as claimed in claim 3, **characterized in that** the heat sink (20) is a component inserted in the housing (10) and **in that** the heat sink (20) has thermal conductivity greater than that of the housing (10).

5. The item of electronic equipment as claimed in claim 3, **characterized in that** the housing (10) comprises a plate (21) and a protrusion (22) protruding from the plate (21), against which protrusion (22) bears the board (11) and **in that** the heat sink (20) is disposed in the protrusion (22).

6. The item of electronic equipment as claimed in any one of claims 1 and 2, **characterized in that** the heat sink (20) is integral with the board (11).

7. The item of electronic equipment as claimed in claim 6, **characterized in that** it comprises a bracket (28) fixed to the board (11) and a thermal retainer (29) fixed to the bracket (28), **in that** the heat sink (20) is disposed in the bracket (28) and **in that** the thermal retainer (29) ensures the pressing of the board (11) against a face (15) of the groove (13).

8. The item of electronic equipment as claimed in any one of the preceding claims, **characterized in that** the extraction means (25) comprise a thermal connector (30) making it possible to connect the heat sink (20) to a cold source (31) outside of the equipment.

9. The item of electronic equipment as claimed in any one of the preceding claims, **characterized in that** the extraction means (25, 30) are located at the level of the rear face (18).
